# EUROPÄISCHE PATENTANMELDUNG

(11) **EP 3 561 887 A1**
(43) Veröffentlichungstag der Anmeldung: **30.10.2019**
(21) Anmeldenummer: 19164929.2
(22) Anmeldetag: 25.03.2019
(51) Int. Cl.: H01L 35/02, H01L 35/30, G08C 17/02, G05B 19/042

(54) **VORRICHTUNG ZUR ANORDNUNG AN EINER KOMPONENTE EINER INDUSTRIEANLAGE**

(30) Priorität: 27.04.2018 DE 102018110165
(71) Anmelder: Gemü Gebr. Müller Apparatebau GmbH & Co. Kommanditgesellschaft, 74653 Ingelfingen (DE)
(72) Erfinder: Nicoleit, Thomas, 75334 Staubenhardt (DE); Ripsam, Marcus, 74653 Ingelfingen (DE)
(74) Vertreter: DREISS Patentanwälte PartG mbB

(57) **Zusammenfassung**

Es wird eine Vorrichtung (2) zur Anordnung an einer Komponente einer Industrieanlage bereitgestellt. Die Vorrichtung umfasst: Eine Heißseite (6) und eine von der Heißseite (6) abgewandte Kaltseite (4); einen thermoelektrischen Generator (8), welcher mit der Heißseite (6) und der Kaltseite (4) thermisch leitend verbunden ist; ein Funkmodul (14), welches zur Aussendung eines Ortungssignals (26) auf einem Funkkanal ausgebildet ist; eine Leistungselektronik (10) und einen Akkumulator (12), welche zu einer Stromversorgung des Funkmoduls (14) in Abhängigkeit von von dem thermoelektrischen Generator (8) erzeugtem Strom ausgebildet sind.

## Beschreibung

Die Erfindung betrifft eine Vorrichtung zur Anordnung an einer Komponente einer Industrieanlage.

Es ist bekannt, dass Industrieanlagen häufig pauschal gewartet werden. Das bedeutet, dass in regelmäßigen Zeitabständen eine komplette Wartung der gesamten Anlage durchgeführt wird. Unabhängig vom jeweiligen Verschleiß bzw. unabhängig von der erwarteten Lebensdauer der einzelnen Komponenten soll auf diese Art und Weise der Betrieb der Anlage sichergestellt werden.

Damit einher gehen hohe Kosten für die Wartung. Darüber hinaus werden häufig Komponenten getauscht, welche regelmäßig eine höhere Lebensdauer haben. Folglich wäre eine Wartung einzelner Komponenten deutlich günstiger und kann die gewünschte Verfügbarkeit gleichermaßen gewährleisten.

In der Praxis wird der Monteur beispielsweise mit folgendem Problem konfrontiert: Ein Ventil mit einer bestimmten Kennung soll in einer Halle, in der um die 1000 Ventile verbaut sind, gewartet werden. So kann es passieren, dass der Monteur für das Auffinden des Ventils mehr Zeit als für die eigentliche Wartung benötigt.

Folglich ist es Aufgabe der Erfindung, die Wartung einer Industrieanlage zu verbessern.

Die Aufgabe wird durch eine Vorrichtung nach dem Anspruch 1 und ein Verfahren nach einem nebengeordneten Anspruch gelöst.

Gemäß einem ersten Aspekt wird eine Vorrichtung bereitgestellt, welche umfasst: Eine Heißseite und eine von der Heißseite abgewandte Kaltseite; einen thermoelektrischen Generator, welcher mit der Heißseite und der Kaltseite thermisch leitend verbunden ist; ein Funkmodul, welches zur Aussendung eines Ortungssignals auf einem Funkkanal ausgebildet ist; und eine Leistungselektronik und einen Akkumulator, welche zu einer Stromversorgung des Funkmoduls in Abhängigkeit von einem von dem thermoelektrischen Generator erzeugten elektrischen Strom ausgebildet sind.

In einer fluidtechnischen Industrieanlage sind typischerweise mehrere hundert bis mehrere tausend Ventile verteilt angeordnet. Die Vorrichtung wird am Ventil oder in der Nähe des Ventils an einem Rohrabschnitt angeordnet. Das das Ventil und den Rohrabschnitt durchfließende Fluid ist typischerweise wärmer oder kälter als die Umgebungsluft. So reicht schon ein wenige Grad Celsius umfassender Temperaturunterschied aus, um mithilfe des thermoelektrischen Generators so viel Energie zu gewinnen, dass das insbesondere diskrete Ortungssignal auf dem Funkkanal gesendet werden kann. Ein mobiles Endgerät empfängt die Ortungssignale verschiedener Vorrichtungen, um den Wartungsarbeiter an die Stelle zu navigieren, an der sich die Vorrichtung und auch die zu wartende Komponente wie beispielsweise ein Ventil befindet.

Wenn man beispielhaft von einer 10-jährigen Lebensdauer einer fluid-technischen Anlagenkomponente wie beispielsweise einem Ventil ausgeht, so reichen übliche Lebensdauern von Batterien nicht aus, um die Vorrichtung zu betreiben. Mithin stellt das Vorsehen des thermoelektrischen Generators einen dahingehenden Vorteil dar, als dass die Vorrichtung aufgrund der lediglich elektrisch arbeitenden Teile selbst keine zu wartende Komponente darstellt. Folglich werden sowohl die Verfügbarkeit als auch die Zuverlässigkeit der Vorrichtung erhöht.

Durch das mittels der Vorrichtung mögliche Verfahren zur gezielten Ortung einzelner Anlagenkomponenten können auch gezielt Wartungsarbeiten besser durchgeführt werden, da die zu wartende Komponente sich über die Vorrichtung nicht nur eindeutig identifizieren lässt, sondern über ein entsprechendes Verfahren, welches in Software implementiert ist, auch gezielt an-navigieren und damit deutlich schneller auffinden lässt. Folglich kann eine pauschale Wartung aller Anlagenkomponenten durch das gezielte Warten einzelner Anlagenkomponenten ersetzt werden, was kostengünstiger ausfällt. Insbesondere kann die Wartung durch ebenfalls von der Vorrichtung empfangene wartungsrelevante Daten verbessert werden.

Die Vorrichtung erlaubt das Nachrüsten bestehender Anlagen. Durch die örtliche und funktionale Entkopplung vom Ventil wird der Anwendungsbereich der Vorrichtung vergrößert. Insbesondere ist es aufgrund der niedrigen Spannungsniveaus möglich, dass explosionsgeschützte Bereiche mit der Vorrichtung versehen werden. Auch können druckluftbetriebene Anlagen, die keinerlei elektrische Energieversorgung in der Nähe des Ventils bereitstellen, ausgerüstet werden. Des Weiteren bleibt eine Abreinigbarkeit der Ventile gewährleistet.

Ein vorteilhaftes Beispiel zeichnet sich dadurch aus, dass die Vorrichtung dazu ausgebildet ist, um in einem Schlafmodus den Funkkanal nur zeitweise abzuhören, ein Aktivierungssignal während des zeitweisen Abhörens des Funkkanals über den Funkkanal zu empfangen, und in Abhängigkeit von dem Empfang des Aktivierungssignals in einen Wachmodus zu wechseln, in dem das Ortungssignal insbesondere mit einer erhöhten Frequenz versendet wird. Durch den so ausgestalteten Schlafmodus wird die Energieeffizienz verbessert, was den Einsatzbereich der Vorrichtung insbesondere bei Vorliegen eines geringen Temperaturunterschieds zwischen Heiß- und Kaltseite vergrößert.

Ein vorteilhaftes Beispiel zeichnet sich dadurch aus, dass das Ortungssignal eine Kennung der Vorrichtung, eine Kennung einer benachbarten Anlagenkomponente und/oder eine Ortskoordinate der Vorrichtung umfasst. Vorteilhafterweise wird so die Identifikation der zu wartenden Anlagenkomponente vereinfacht, da dem Monteur eine erhöhte Anzahl von Informationen zu der zu wartenden Anlagenkomponente bereitstehen, inklusive der Möglichkeit zur Navigation zu der zu wartenden Komponente.

Ein vorteilhaftes Beispiel zeichnet sich dadurch aus, dass die Vorrichtung einen Sensor umfasst, und dass die Vorrichtung dazu ausgebildet ist, um im Wachmodus ein Sensorsignal des Sensors zu ermitteln, ein weiteres Funksignal in Abhängigkeit von dem ermittelten Sensorsignal zu ermitteln und das weitere Funksignal auf dem Funkkanal zu senden. Durch das Sensorsignal - beispielsweise umfassend eine Fluidtemperatur oder einen Durchflusswert - werden die Wartungsinformationen weiter angereichert.

Ein vorteilhaftes Beispiel zeichnet sich dadurch aus, dass die Vorrichtung dazu ausgebildet ist, um einen Ladezustand des Akkumulators, welcher von der Leistungselektronik ladbar und zur Stromversorgung des Funkmoduls konfiguriert ist, zu ermitteln; und die Wiederholungsrate zum Versand des Ortungssignals und/oder zum Abhören des Funkkanals in Abhängigkeit von dem Ladezustand einzustellen. Durch die Anpassung der Wiederholungsrate wird die Energieeffizienz weiter verbessert.

Ein vorteilhaftes Beispiel zeichnet sich dadurch aus, dass die Vorrichtung ein Leuchtmittel umfasst, und dass die Vorrichtung dazu ausgebildet ist, um ein Auswahlsignal über den Funkkanal zu empfangen, und um das Leuchtmittel zur Abstrahlung einer Lichtverteilung in Abhängigkeit von dem Empfang des Auswahlsignals zu betreiben. Durch die Abstrahlung einer Lichtverteilung - beispielsweise in Form eines Blinkens - in Abhängigkeit von dem Empfang des Auswahlsignals wird optisch signalisiert, an welcher Stelle sich die Vorrichtung befindet. Die Vorrichtung ist somit einfacher auffindbar.

Ein vorteilhaftes Beispiel zeichnet sich dadurch aus, dass die Vorrichtung zumindest abschnittsweise nach Art einer öffen- und schließbaren Manschette ausgebildet ist. Durch die manschetten-artige Ausbildung wird eine verliersichere Anordnung an dem Rohrabschnitt gewährleistet und die Energieversorgung wird durch das Anliegen der Heißseite bzw. Kaltseite an dem Rohrabschnitt verbessert. Insbesondere wird die Heißseite bzw. Kaltseite an den Rohrabschnitt angepresst, um eine bessere Wärmeleitung zu erreichen. Insbesondere ist durch die manschettenartige Ausbildung der Vorrichtung die Nachrüstbarkeit von bestehenden Anlagen gegeben.

Ein vorteilhaftes Beispiel zeichnet sich dadurch aus, dass eine proximale Innenfläche der Vorrichtung zumindest abschnittsweise einer Zylinderinnenfläche folgt. Vorteilhaft ergibt sich damit eine konkav ausgebildete Heißseite bzw. Kaltseite der Vorrichtung, welche auf einfache Art und Weise an einem Rohrabschnitt eines Rohrleitungssystems insbesondere in der Nähe eines Ventils anordenbar ist.

Ein vorteilhaftes Beispiel zeichnet sich dadurch aus, dass ein distaler Abschnitt eine Geometrie zur Oberflächenvergrößerung aufweist. Durch die Geometrie zur Oberflächenvergrößerung, beispielsweise in Form von Kühlkanälen oder Kühlfinnen, ergibt sich ein potenziell erhöhter Wärmestrom durch den thermoelektrischen Generator und die Energieversorgung wird verbessert.

Ein vorteilhaftes Beispiel zeichnet sich dadurch aus, dass der thermoelektrische Generator folienartig ausgebildet ist. Durch die folienartige Ausbildung ist die Vorrichtung einfach an die unterschiedlichsten Wärmekontaktpartner anpassbar. Darüber hinaus wird die Anordnung an Rohrabschnitten verbessert, da der thermoelektrische Generator in eine korrespondierende Form bringbar ist.

Ein vorteilhaftes Beispiel zeichnet sich dadurch aus, dass der thermoelektrische Generator radial innerhalb eines metallischen Trägers angeordnet ist. Dies ist insbesondere bei einer radial innen liegenden Heißseite vorteilhaft.

Ein vorteilhaftes Beispiel zeichnet sich dadurch aus, dass der thermoelektrische Generator radial außerhalb eines metallischen Trägers angeordnet ist. Dies ist insbesondere bei einer radial innen liegenden Kaltseite vorteilhaft.

Ein weiterer Aspekt dieser Beschreibung betrifft ein Verfahren zum Betreiben einer Vorrichtung, wobei die Vorrichtung umfasst: Eine Heißseite und eine von der Heißseite abgewandte Kaltseite; einen thermoelektrischen Generator, welcher mit der Heißseite und der Kaltseite verbunden ist; ein Funkmodul; eine Leistungselektronik und einen Akkumulator; wobei das Verfahren umfasst: Stromversorgen des Funkmoduls in Abhängigkeit von einem von dem thermoelektrischen Generator erzeugten elektrischen Strom mithilfe der Leistungselektronik und des Akkumulators; und Aussenden eines Ortungssignals auf einem Funkkanal mithilfe des Funkmoduls.

Weitere Vorteile und Merkmale der Erfindung sind aus der nachfolgenden Beschreibung von Ausführungsbeispielen der Zeichnung entnehmbar. In der Zeichnung zeigen:
Figur 1 ein schematisches Blockdiagramm einer Vorrichtung;
Figur 2 eine beispielhafte Anwendung der Vorrichtung;
Figuren 3 und 4 jeweils einen schematischen Schnitt einer Ausführungsform der Vorrichtung; und
Figur 5 ein schematisches Sequenzdiagramm.

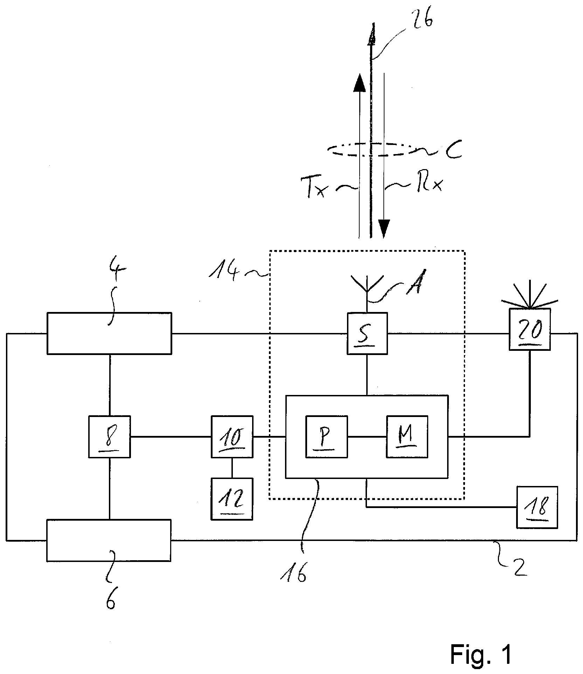

Figur 1 zeigt ein schematisches Blockdiagramm einer Vorrichtung 2, welche zur Anordnung an einer Komponente einer Industrieanlage, insbesondere einer fluidtechnischen Anlage, vorgesehen ist. Die Vorrichtung 2 umfasst eine Kaltseite 4 und eine von der Kaltseite 4 abgewandte Heißseite 6. Ein thermoelektrischer Generator 8 verbindet die Kaltseite 4 und die Heißseite 6 thermisch leitend und erzeugt elektrische Energie. Der thermoelektrische Generator 8 erzeugt elektrische Energie unter Ausnutzung eines Temperaturunterschiedes zwischen der Kaltseite 4 und der Heißseite 6 der Vorrichtung 2. Diese elektrische Energie wird von einer Leistungselektronik 10 in einem Akkumulator 12 gespeichert. Die Leistungselektronik 10 ist gemeinsam mit dem Akkumulator 12 so ausgebildet, dass ein Funkmodul 14 mit elektrischem Strom versorgt wird.

Das Funkmodul 14 umfasst eine Steuereinheit 16 mit zumindest einem Prozessor P und einem Speicherelement M, auf welchem ein Computerprogrammprodukt abgespeichert ist, welches auf dem Prozessor P zur Ausführung der in dieser Beschreibung erläuterten Verfahrensschritte ausgebildet ist. Des Weiteren umfasst das Funkmodul 14 eine Funkschnittstelle S und eine Antenne A, um über einen Funkkanal C Daten Tx, insbesondere ein Ortungssignal 26, zu senden und Daten Rx zu empfangen. Ein Sensor 18 ist mit der Steuereinheit 16 verbunden, um Sensordaten an die Steuereinheit 16 zu übermitteln. Die Steuereinheit 16 sorgt für den Versand der erhaltenen Sensordaten auf dem Funkkanal C. Die Vorrichtung 2 umfasst ein Leuchtmittel 20, welches zur Abstrahlung einer Lichtverteilung von der Steuereinheit 16 betreibbar ist.

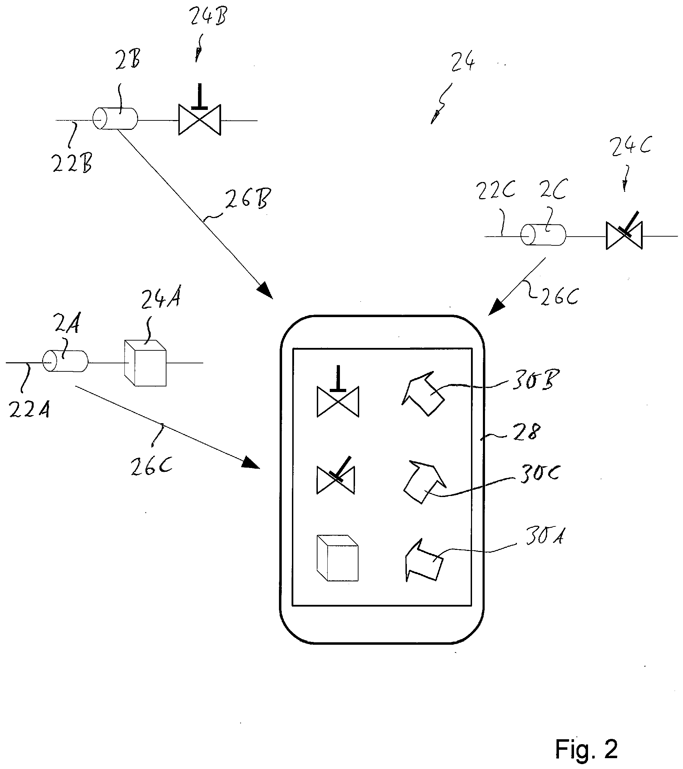

Figur 2 zeigt eine beispielhafte Anwendung der Vorrichtung 2 aus Figur 1. Eine Anzahl von Vorrichtungen 2A, 2B und 2C, welche der Vorrichtung 2 aus Figur 1 entsprechen, sind an einem jeweiligen Leitungsabschnitt 22A, 22B und 22C einer Industrieanlage 24 angeordnet. Die Vorrichtungen 2A, 2B und 2C sind jeweils in der Nähe einer zugeordneten Anlagenkomponente 24A, 24B und 24C angeordnet, wobei die Anlagenkomponenten 24B und 24C Fluidventile unterschiedlichen Typs darstellen. Jede der Vorrichtungen 2A, 2B, 2C wurde bei der Installation oder davor mit einer eindeutigen Identifikationskennung versehen und mit Anlagendaten wie beispielsweise dem Anlagenaufbau und/oder dem Typenschlüssel verknüpft. Die Identifikationskennung stimmt beispielsweise mit einer Kennung der zugeordneten Anlagenkomponente 24A, 24B, 24C überein. Die jeweilige Vorrichtung 2A, 2B, 2C versendet ein jeweiliges Ortungssignal 26A, 26B und 26C auf dem Funkkanal.

Die Ortungssignale 26A, 26B und 26C werden von einem Endgerät 28 beispielsweise einem Mobilfunktelefon oder einem Tablettcomputer empfangen. Durch Tri- oder Multilateration oder andere Auswertemethoden ermittelt das Endgerät 28 seine eigene Position relativ zu den Vorrichtungen 2A, 2B und 2C. Bei der Trilateration ermöglichen drei Vorrichtungen 2 die Positionsbestimmung. Bei der Multilateration ermöglichen mehr als drei Vorrichtungen 2 die Positionsbestimmung. Je mehr Vorrichtungen 2 zur Positionsbestimmung verwendet werden, desto genauer kann die Position bestimmt werden. In Abhängigkeit von der Position des Endgeräts 28 und den empfangenen Ortungssignalen 26A-26C ermittelt das Endgerät 28 Positionsangaben 30A, 30B und 30C und stellt diese für den Benutzer beispielsweise in Form von Pfeilen bereit. Die dargestellten Positionsangaben 30A-30C werden beispielsweise bei Änderung der Position oder Ausrichtung des Endgeräts 28 mithilfe eines Gyroskopsignals eines Gyroskopsensors des Endgeräts 28 aktualisiert. Selbstverständlich kann die Navigation auch mithilfe einer anderen Darstellung durchgeführt werden. In einem weiteren Beispiel können pulsende Kreise auf dem Endgerät 28 dargestellt werden, deren jeweilige Pulsfrequenz je nach dem, ob man das Endgerät 28 in Richtung der gesuchten Komponente hält, verändert wird. In einem weiteren Beispiel wird das Bild einer Kamera des Endgeräts 28 auf dem Bildschirm angezeigt und der Bildbereich, in dem sich die aufzufindende Komponente befindet, wird hervorgehoben. Die Hervorhebung kann beispielsweise durch einen pulsenden Kreis oder ein Blinken eines Symbols an einer der aufzufindenden Komponente entsprechenden Stelle im dargestellten Bild realisiert sein.

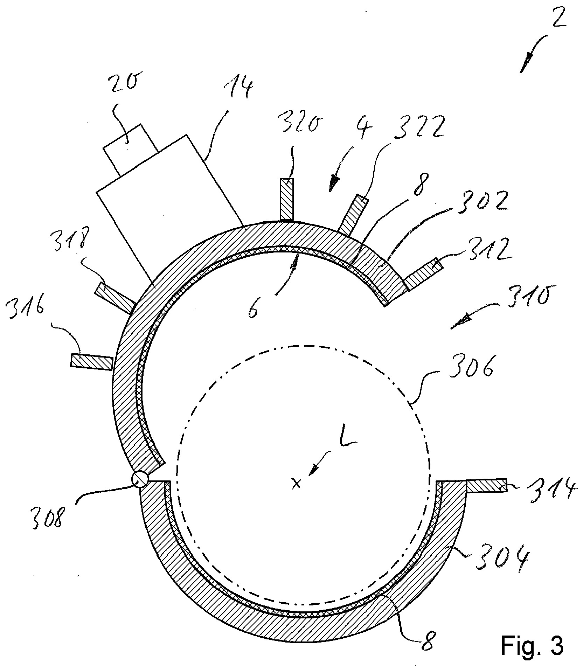

Figur 3 zeigt in einem schematischen Schnitt eine Ausführungsform der Vorrichtung 2 aus Figur 1. Der Schnitt ist lotrecht zu einer Längsachse L der Vorrichtung 2 dargestellt. Die Vorrichtung 2 folgt im Wesentlichen einer hohlzylindrischen Form, um einen Rohrabschnitt zu umschließen. Damit stellt die Vorrichtung 2 eine Manschette dar, welche an dem Rohrabschnitt angeordnet wird. Der thermoelektrische Generator 8 ist als flexible Folie ausgebildet und radial innerhalb eines jeweiligen metallischen Trägers 302, 304 fest angeordnet. Diese Konfiguration ist dann vorteilhaft, wenn in der Rohrleitung, deren Außenkontur schematisch mit dem Bezugszeichen 306 versehen ist, ein Fluid mit einer Temperatur fließt, welche höher ist als die Temperatur der Umgebungsluft, der die Kaltseite 4 ausgesetzt ist. Selbstverständlich können noch weitere nicht gezeigte Schichten vorgesehen sein. Beispielsweise ist der thermoelektrische Generator 8 von einer flexiblen und wärmeleitenden Schicht umgeben.

Das Funkmodul 14 ist auf dem metallischen Träger 302 angeordnet. Das Funkmodul 14 kann selbstverständlich auch auf dem metallischen Träger 204 angeordnet sein. Das Leuchtmittel 20 ist gut sichtbar am distalen Ende des Funkmoduls 14 angeordnet. Des Weiteren verbindet ein Scharnier 308 die metallischen Träger 302 und 304 derart, dass ein Rohrabschnitt gemäß der Außenkontur 306 durch eine Öffnung 310 hierdurch in die Vorrichtung 2 einführbar ist und die Vorrichtung 2 anschließend das Rohr mit der Außenkontur 306 umgreift. Selbstverständlich kann anstatt des Scharniers 308 wenigstens ein anderes die Manschetten-Hälften verbindendes Verbindungselement vorgesehen sein. Nach dem Schließen der Öffnung 310 dienen schematisch dargestellte Verbindungsmittel 312 und 314 dazu, eine großflächige und dauerhafte Anpressung der Vorrichtung 2 an den jeweiligen Rohrabschnitt zu erreichen. Die Verbindungsmittel 312, 314 stellen beispielsweise einen Schnellspannverschluss, einen Bajonettverschluss, eine Verschraubung oder Ähnliches dar.

In einem Beispiel ist der thermoelektrische Generator 8 als ein kompressibles Element - beispielsweise umfassend eine kompressible Folie - ausgebildet, um trotz leicht unterschiedlicher Außenkonturen insbesondere unterschiedlicher Außendurchmesser des Rohrabschnitts eine großflächige Anpressung der Vorrichtung 2 in deren Innenbereich an den Rohrabschnitt zu erreichen. Durch eine großflächige Anpressung wird die Übertragung großer Wärmeenergiemengen erreicht. Der metallische Träger 302 weist im vorliegenden Beispiel sich in Längsrichtung bzw. parallel zur Längsachse L erstreckende Finnen 316-322 auf, welche die Oberfläche der Kaltseite 4 vergrößern und damit den Wärmefluss durch den thermoelektrischen Generator 8 erhöhen.

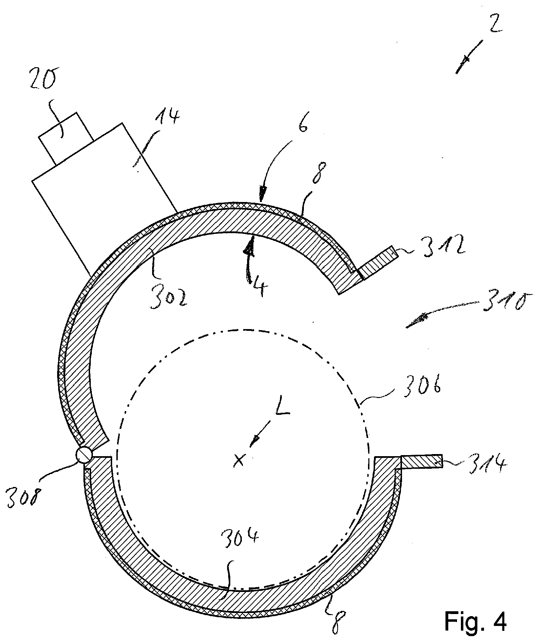

Figur 4 zeigt einen schematischen Schnitt einer Ausführungsform der Vorrichtung 2 aus Figur 1. Im Unterschied zu Figur 3 ist der thermoelektrische Generator 8 radial außerhalb des jeweils zugeordneten metallischen Trägers 302, 304 angeordnet. Diese Ausführung ist insbesondere dann vorteilhaft, wenn in der Rohrleitung ein Fluid mit einer Temperatur fließt, welche niedriger ist als die Temperatur der Umgebungsluft.

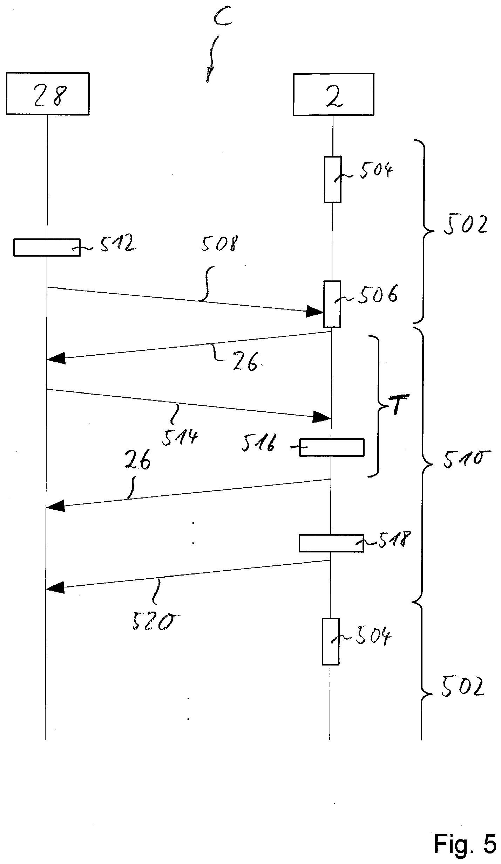

Figur 5 zeigt ein schematisches Sequenzdiagramm. In einem Schlafmodus 502 hört die Vorrichtung 2 den Funkkanal nur zeitweise in Abschnitten 504, 506 ab. In dem Abschnitt 506 empfängt die Vorrichtung 2 ein Aktivierungssignal 508 und wechselt in einen Wachmodus 510. In dem Wachmodus 510 ist die Vorrichtung 2 stets empfangsbereit geschaltet. Nach einer vorbestimmten Zeitdauer nach Empfang des Aktivierungssignals 508 oder nach einem Empfang eines Signals "zum Schlafen-Gehen" geht die Vorrichtung 2 vom Wachmodus 510 in den Schlafmodus 502 über, um wieder zeitweise den Funkkanal C abzuhören. In einem Schritt 512 wird das Endgerät 28 zur Ortung der jeweiligen Vorrichtung 2 aktiviert, um anschließend das Aktivierungssignal 508 an eine oder mehrere Vorrichtungen 2 zu versenden.

Im Wachmodus 510 versendet die Vorrichtung 2 in regelmäßigen Abständen T das Ortungssignal 26, um aufgefunden zu werden. Die Abstände T bzw. die Wiederholungsrate zum Versand des Ortungssignals 26 und/oder zum Abhören des Funkkanals im Schlafmodus werden in Abhängigkeit von dem Ladezustand des Akkumulators eingestellt. Beispielsweise wird bei einem erhöhten Ladezustand die Wiederholungsrate sowohl zum Abhören des Funkkanals als auch zum Versand des Ortungssignals erhöht.

Hierzu wird zuvor der Ladezustand des Akkumulators ermittelt.

Wählt der Benutzer des Endgeräts 28 die Vorrichtung 2 zu deren Ortung aus, wird ein Auswahlsignal 514 an die Vorrichtung 2 versendet. Die Vorrichtung 2 betreibt auf Empfang des Auswahlsignals 514 hin in einem Schritt 516 das Leuchtmittel zur Abstrahlung einer Lichtverteilung, beispielsweise in Form eines Blinkens.

Im Schritt 518 wird ein Sensorsignal des Sensors 18 aus Figur 1 ermittelt und über den Funkkanal C in Form eines weiteren Funksignals 520 an das Endgerät 28 versendet.

## Patentansprüche

1. Eine Vorrichtung (2) zur Anordnung an einer Komponente einer Industrieanlage, wobei die Vorrichtung umfasst:
eine Heißseite (6) und eine von der Heißseite (6) abgewandte Kaltseite (4);
einen thermoelektrischen Generator (8), welcher mit der Heißseite (6) und der Kaltseite (4) thermisch leitend verbunden ist;
ein Funkmodul (14), welches zur Aussendung eines Ortungssignals (26) auf einem Funkkanal ausgebildet ist;
eine Leistungselektronik (10) und einen Akkumulator (12), welche zu einer Stromversorgung des Funkmoduls (14) in Abhängigkeit von einem von dem thermoelektrischen Generator (8) erzeugten elektrischen Strom ausgebildet sind.

2. Die Vorrichtung (2) nach Anspruch 1, wobei die Vorrichtung (2) dazu ausgebildet ist, um
in einem Schlafmodus den Funkkanal nur zeitweise abzuhören,
ein Aktivierungssignal während des zeitweisen Abhörens des Funkkanals über den Funkkanal zu empfangen, und
in Abhängigkeit von dem Empfang des Aktivierungssignals in einen Wachmodus zu wechseln, in dem das Ortungssignal (26) versendet wird.

3. Die Vorrichtung (2) nach dem Anspruch 2, wobei das Ortungssignal (26) eine Kennung der Vorrichtung (2), eine Kennung einer benachbarten Anlagenkomponente und/oder eine Ortskoordinate der Vorrichtung (2) umfasst.

4. Die Vorrichtung (2) nach dem Anspruch 1 oder 2, wobei die Vorrichtung (2) einen Sensor (18) umfasst, und wobei die Vorrichtung (2) dazu ausgebildet ist, um im Wachmodus
ein Sensorsignal des Sensors (18) zu ermitteln,
ein weiteres Funksignal in Abhängigkeit von dem ermittelten Sensorsignal zu ermitteln, und
das weitere Funksignal auf dem Funkkanal zu senden.

5. Die Vorrichtung (2) nach einem der vorstehenden Ansprüche, wobei die Vorrichtung (2) dazu ausgebildet ist, um
einen Ladezustand des Akkumulators (12), welcher von der Leistungselektronik (10) ladbar und zur Stromversorgung des Funkmoduls (14) konfiguriert ist, zu ermitteln; und
die Wiederholungsrate zum Versand des Ortungssignals (26) und/oder zum Abhören des Funkkanals in Abhängigkeit von dem Ladezustand einzustellen.

6. Die Vorrichtung (2) nach einem der vorstehenden Ansprüche, wobei die Vorrichtung (2) ein Leuchtmittel (20) umfasst, und wobei die Vorrichtung (2) dazu ausgebildet ist, um
ein Auswahlsignal über den Funkkanal zu empfangen, und
das Leuchtmittel (20) zur Abstrahlung einer Lichtverteilung in Abhängigkeit von dem Empfang des Auswahlsignals zu betreiben.

7. Die Vorrichtung (2) nach einem der vorstehenden Ansprüche, wobei die Vorrichtung (2) zumindest abschnittsweise nach Art einer öffen- und schließbaren Manschette ausgebildet ist.

8. Die Vorrichtung (2) nach einem der vorstehenden Ansprüche, wobei eine proximale Innenfläche der Vorrichtung (2) zumindest abschnittsweise einer Zylinderinnenfläche folgt.

9. Die Vorrichtung (2) nach einem der vorstehenden Ansprüche, wobei ein distaler Abschnitt eine Geometrie zur Oberflächenvergrößerung aufweist.

10. Die Vorrichtung (2) nach einem der vorstehenden Ansprüche, wobei der thermoelektrische Generator (9) folienartig ausgebildet ist.

11. Die Vorrichtung (2) nach einem der vorstehenden Ansprüche, wobei der thermoelektrische Generator (8) radial innerhalb eines metallischen Trägers (302; 304) angeordnet ist.

12. Die Vorrichtung (2) nach einem der Ansprüche 1 bis 10, wobei der thermoelektrische Generator (8) radial außerhalb eines metallischen Trägers (302; 304) angeordnet ist.

13. Ein Verfahren zum Betreiben einer Vorrichtung (2), wobei die Vorrichtung (2) umfasst: Eine Heißseite (6) und eine von der Heißseite (6) abgewandte Kaltseite (4); einen thermoelektrischen Generator (8), welcher mit der Heißseite (6) und der Kaltseite (4) thermisch leitend verbunden ist; ein Funkmodul (14); eine Leistungselektronik (10); und einen Akkumulator(12); wobei das Verfahren umfasst:
Stromversorgen des Funkmoduls (14) in Abhängigkeit von einem von dem thermoelektrischen Generator (8) erzeugten elektrischen Strom mithilfe der Leistungselektronik (10) und des Akkumulators (12); und
Aussenden eines Ortungssignals (26) auf einem Funkkanal mithilfe des Funkmoduls (14).
